# EUROPEAN PATENT SPECIFICATION

(11) **EP 0 683 603 B1**
(45) Date of publication and mention of the grant of the patent: **22.12.1999**
(21) Application number: 95202218.4
(22) Date of filing: 22.10.1987
(51) Int. Cl.: H04N 3/15, H01L 27/14

(54) **Electronic shutter for electronic camera**
Elektronischer Verschluss für elektronische Kamera
Obturateur électronique pour caméra électronique

(30) Priority: 23.10.1986 JP 25237586; 23.12.1986 JP 30747486
(43) Date of publication of application: 22.11.1995
(62) Divisional of application: 87309365.2
(73) Proprietor: SONY CORPORATION, Tokyo (JP)
(72) Inventor: Yonemoto, Kazuya, c/o Intellectual Property Div., Shinagawa-ku, Tokyo 141 (JP); Ishikawa, Kikue, c/o Intellectual Property Div., Shinagawa-ku, Tokyo 141 (JP); Hamasaki, Masaharu, c/o Intellectual Property Div., Shinagawa-ku, Tokyo 141 (JP); Kagawa, Yoshiaki, c/o Intellectual Property Div., Shinagawa-ku, Tokyo 141 (JP); Suzuki, Tomoyuki, c/o Intellectual Property Div., Shinagawa-ku, Tokyo 141 (JP)
(74) Representative: Williams, Janice

(56) References cited:
- DE-A- 3 326 924
- DE-A- 3 514 994
- US-A- 4 589 024
- PATENT ABSTRACTS OF JAPAN vol. 5 no. 103 (E-064) ,3 July 1981 & JP-A-56 044271 (SONY CORP)

## Description

This invention relates to solid state imager devices, to methods of utilizing a solid state imager device as an electronic shutter, and generally to electronic shuttering, for example, for an electronic camera such as a video camera or an electronic still camera.

It has been required that a solid state imager device be able to control its exposure time by electronic means provided therein, so that when the imager device is used in, for example, a video camera, the use of a mechanical shutter as hitherto proposed, is unnecessary. Without a mechanical shutter, a video camera could be made smaller, lighter, and cheaper.

There has already been proposed a solid state imager device which permits selection between two exposure times, one long and one short. This imager device has one of the two exposure times chosen to be 1/30 second, which is equal to one frame period in the NTSC television system, and the other exposure time chosen to be about 1/2000 second, which is equal to a vertical blanking period.

In this imager device, when the 1/30 second exposure time is selected, signal charges accumulated in the light receiving section during one frame period are read out as an image signal. On the other hand, when the 1/2000 second exposure time is selected, signal charges accumulated before a vertical blanking period are read out to a vertical register section and discharged by a high speed transfer, while signal charges newly accumulated only during the vertical blanking period are read out as an image signal.

However, this imager device is limited in that it only allows selection between two exposure times so that, even when a video camera is equipped with such an imager device, it still requires a mechanical shutter. Moreover, since a high speed transfer is required to discharge the signal charges accumulated before a vertical blanking period to the vertical register, the imager device consumes excessive electric power.

DE-A-3326924 discloses a solid state CCD camera with an electronic shutter, comprising a solid state imager having a n type semiconductor substrate and a p type region formed on this substrate. The device further comprises a signal charge accumulating region formed on a surface of the p type region and means for applying a predetermined voltage (a discharge signal) to the substrate to thereby discharge signal charges accumulated in this region. The device is used such that a discharge signal is applied during a non-exposure time, i.e. when the shutter is "closed", and is not applied during an exposure.

According to one aspect of the present invention there is provided an electronic shutter for an electronic camera, the shutter comprising:
a solid state imager device having a semiconductor substrate of a first conductivity type;
a region of a second conductivity type formed on said substrate; a signal charge accumulating region formed on a surface side of said second conductivity type region; and
means for applying a predetermined voltage to said substrate thereby to discharge signal charges accumulated in said signal charge accumulating region to said substrate; wherein
said means for applying said predetermined voltage is arranged to apply said predetermined voltage to said substrate by selecting the time of supply of a discharging pulse (P₁), and said discharging pulse (P₁) is applied to said substrate just before the exposure time is started, and is not applied to said substrate for some of the non-exposure time.

According to another aspect of the invention there is provided a method of utilizing a solid state imager device as an electronic shutter for an electronic camera, comprising the step of applying a predetermined voltage to a semiconductor substrate of a first conductivity type having a region of a second conductivity type formed thereon, thereby to discharge signal charges accumulated in a signal charge accumulating region formed on a surface side of said second conductivity type region to said substrate; and
selecting the time of supply of a discharging pulse (P₁) to apply said predetermined voltage to said substrate, wherein said discharging pulse (P₁) is applied to said substrate just before the start of the exposure time, and is not applied to said substrate for some of the non-exposure time.

The invention will now be described by way of example with reference to the accompanying drawings, in which:
Figure 1 is a cross-sectional view showing an embodiment of solidstate imager device according to the present invention;
Figure 2 is a graph showing potentials of respective regions of the imager device of Figure 1 in the depth direction thereof;
Figures 3A and 3B are timing charts for explaining a shutter function of the imager device; and
Figures 4A to 4E are timing charts for explaining another shutter function of the imager device.

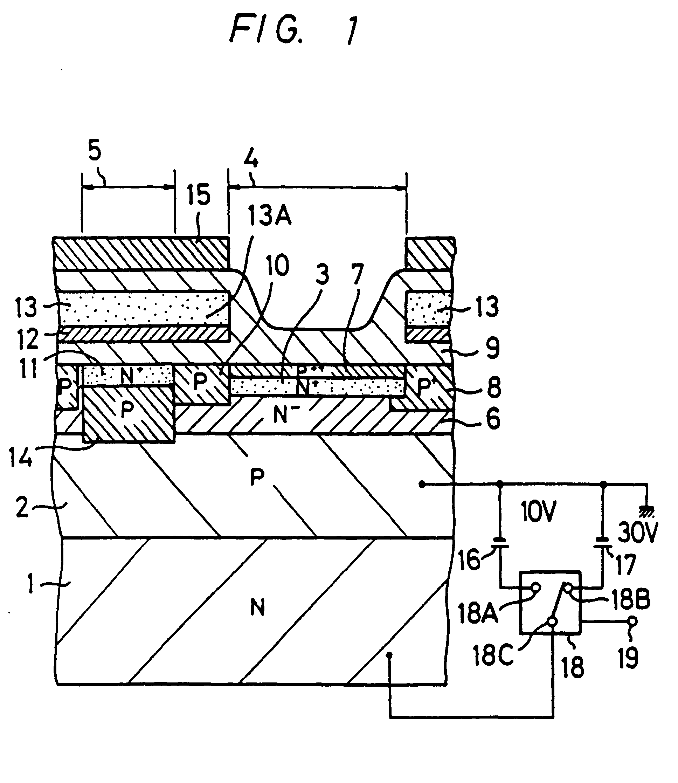

The solid state image device of Figure 1 comprises an N type silicon substrate 1 upon which a light receiving section 4, a vertical register section 5, a horizontal register section (not shown) and an output section (not shown) are formed, so as to constitute a so-called interline transfer charge coupled device (CCD) type imager device. On the surface of the substrate 1 there is deposited, for example, by epitaxial growth techniques, a P type region 2. An N⁻ type region 6 is deposited on the surface of the P type region 2.

The light receiving section 4 is formed of a shallow P⁺⁺ type region 7 formed in a surface region of the N⁻ type region 6 and an N⁺ type region 3 is formed beneath the P⁺⁺ type region 7 to constitute a signal charge accumulating region. There is also a P⁺ type region 8 constituting a channel stopper section formed adjacent to the P⁺⁺ type region 7 and the N⁺ type region 3. An insulating layer 9 made of SiO₂ is deposited on the P⁺⁺ type region 7.

The vertical register section 5 is formed such that an N⁺ type region 11, which constitutes a signal charge transfer region, is formed adjacent to a P type region 10, which constitutes a read-out gate region. A transfer electrode 13 made of polysilicon and another insulating layer 12 made of Si₃N₄ are formed above the N⁺ type region 11 within the SiO₂ insulating layer 9. One end portion of the transfer electrode 13 is also used as a read-out gate electrode 13A. A P type region 14 is formed, for preventing smear, beneath the N⁻ type region 11. An aluminium layer 15 for shielding light is deposited above the transfer electrode 13 above the insulating layer 9.

Although only two of the transfer electrodes 13 are illustrated in Figure 1, there are disposed a predetermined number of transfer electrodes 13 such that the vertical register section 5 is driven in known manner by a four-phase drive. The horizontal register section and the output section which are not illustrated in the drawing, are of known form.

In the embodiment of Figure 1, the negative voltage terminals of direct current (DC) power supply sources 16 and 17 are commonly connected to the P type region 2 and earthed. The positive voltage terminals of the sources 16 and 17 are connected to first and second fixed contacts 18A and 18B, respectively, of a switching circuit 18. A movable contact 18C of the switching circuit 18 is connected to the substrate 1.

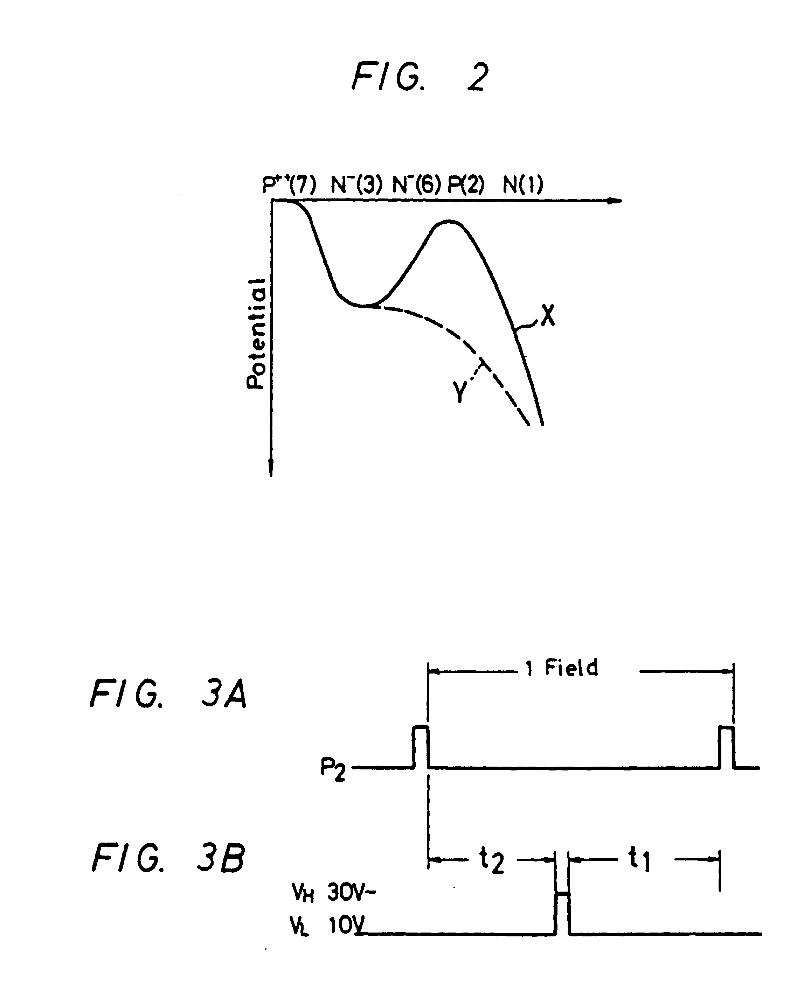

An output voltage V_{L} from the source 16 is selected to be a value, for example, 10 volts, such that when the voltage V_{L} is applied to the substrate 1, the potential in the P type region 2 becomes slightly lower than the potential of the shallow P⁺⁺ type region 7 on the surface of the N⁺ type region 3, as shown by a solid line X in Figure 2, so that signal charges can be accumulated in the N⁺ type signal charge accumulating region 3 and blooming can be effectively suppressed. An output voltage V_{H} from the source 17 is selected to be a value, for example 30 volts, such that when the voltage V_{H} is applied to the substrate 1, the potential in the P type region 2 becomes lower than the potential in the signal charge accumulating region 3, as is shown by a broken line Y in Figure 2, so that the signal charges accumulated in the signal charge accumulating region 3 can be discharged to the substrate 1. Switching of the switching circuit 18 can be controlled by a control signal supplied thereto through a control signal input terminal 19.

In this embodiment, when a read-out pulse P₂, as shown in Figure 3A, is supplied to the read-out gate electrode 13A while the output voltage V_{L} from the source 16 is applied to the substrate 1, signal charges accumulated in the signal charge accumulating region 3 are read out to the vertical register section 5. Therefore, in the present embodiment, the read-out pulse P₂ is supplied to the read-out gate electrode 13A at every field within the vertical retrace.

After the read-out pulse P₂ has been supplied to the read-out gate electrode 13A, if the switching circuit 18 is controlled so as to supply the substrate 1 with the 30 volts pulse, that is supplying a discharging pulse P₁ at a desired time within one field period as shown in Figure 3B, signal charges accumulated in the signal charge accumulating region 3 for a period t₂, that is a period from the time the proceeding read-out pulse P₂ is applied to the read-out gate electrode 13A to the time the current discharging pulse P₁ is applied to the substrate 1, are transferred to the substrate 1. Therefore, when the next read-out pulse P₂ is supplied to the read-out gate electrode 13A, signal charges accumulated in the signal charge accumulating region 3 for the period t₁, that is a period from the supply of the present read-out pulse P₂, are read out to the vertical register section 5.

As described above, the exposure time of the imager device becomes the period t₁, so that a desired exposure time can be obtained by selecting the time of supply of the discharging pulse P₁ to the substrate 1. Accordingly, when this imager device is used in a video camera, it does not have to be provided with a mechanical shutter, so that it is possible to reduce the size, weight and manufacturing cost of the camera.

Furthermore, for discharging the signal charges, the imager device does not have to operate the vertical register section 5 at a high speed as do the previously proposed solid state imager devices. The present imager device only requires, for example, a pulse of 30 volts to be applied to the substrate 1, so that the electric power necessary for the exposure control can be substantially reduced.

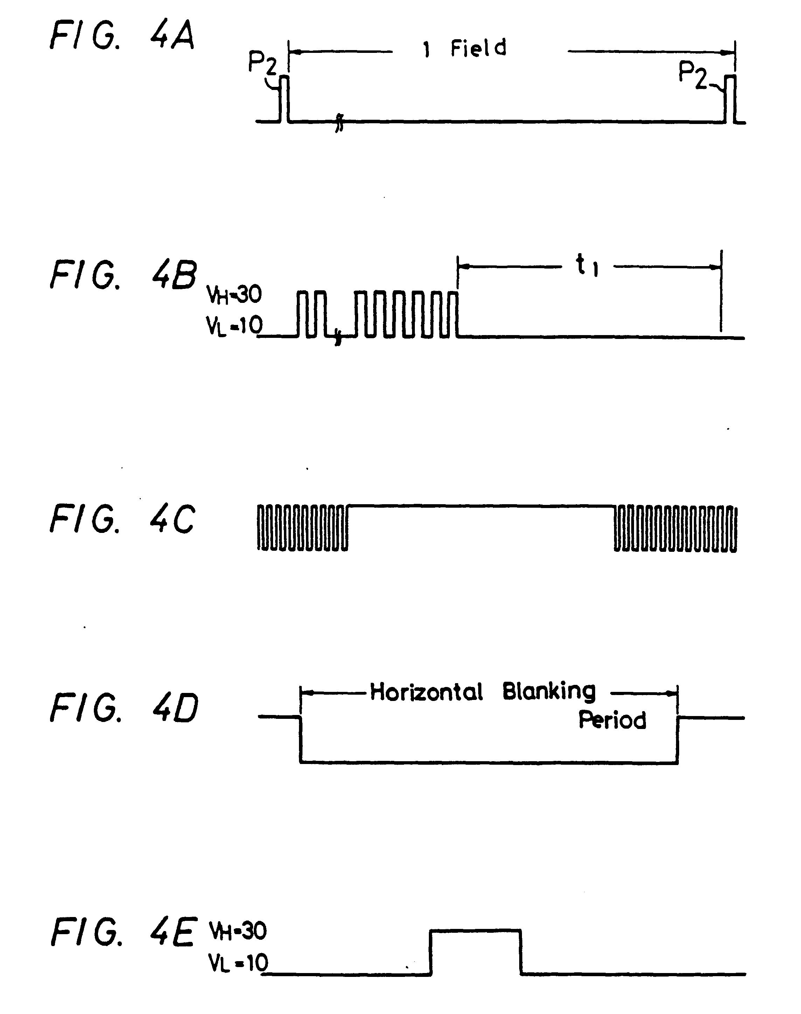

With reference now to Figures 1 and 4A to 4E, another method for controlling the exposure time of the imager device will be explained.

In this method, after signal charges accumulated in the signal charge accumulating region 3 for the preceding field period have been read out by the read-out pulse P₂ shown in Figure 4A (the same as that shown in Figure 3A) to the vertical register section 5, the voltage V_{H} (30 volts) is applied from the source 16 through the switching circuit 18 to the substrate 1 so as to discharge the signal charges accumulated in the signal charge accumulating region 3 in such a manner that an arbitrary number of the horizontal blanking periods, each being set at 63.5 microseconds, are successively selected. During the horizontal blanking periods thus selected, the switching circuit 18 is controlled by the control signal applied thereto from the terminal 19 so that the movable contact 18C engages the second fixed contact 18B. In other words, after the signal charges have been read out by the read-out pulse P₂, the voltage V_{H} (30 volts) is applied to the substrate 1 at every horizontal blanking period to discharge the signal charges accumulated in the signal charge accumulating region 3 until immediately before the exposure is started. During the exposure time period t₁ (Figure 4B), the voltage V_{L} (10 volts) is applied from the source 16 through the switching circuit 18 to the substrate 1 to accumulate signal charges in the signal charge accumulating region 3. Figure 4C shows a horizontal clock signal while Figure 4D shows a horizontal blanking signal, and Figure 4E shows the voltages to be applied to the substrate 1 within the horizontal blanking period.

With the method just described, the exposure time t₁ can be changed in a range between 1/60 and 1/10000 of a second by selecting the number of horizontal blanking periods for discharging the signal charges accumulated in the signal charge accumulating region 3, as shown in Figure 4B.

As described above, the exposure time is controlled by changing the voltage applied to the substrate 1. Since the voltage V_{H} is applied to the substrate 1 within the horizontal blanking period, even although a buffer amplifier and other devices forming the output section are caused to fluctuate by changing the voltage applied to the substrate 1, the reproduced image will not be influenced by the above change, so that it is possible to obtain reproduced images with a constant contrast.

The above description relates to where the signal charges are discharged at every horizontal blanking period until immediately before the exposure is started. Modifications can be made dependent on the characteristics of a solid state imager device, such as where the signal charges are discharged only once within the horizontal blanking period immediately before the exposure is started, or where some of the horizontal blanking periods before the exposure is started are selected to discharge the signal charges. In other words, the number of discharges can be selected in accordance with the characteristics of each solid state imager device.

## Claims

1. An electronic shutter for an electronic camera, the shutter comprising:
a solid state imager device having a semiconductor substrate (1) of a first conductivity type;
a region (2) of a second conductivity type formed on said substrate (1);
a signal charge accumulating region (3) formed on a surface side of said second conductivity type region; and
means (16 to 19) for applying a predetermined voltage to said substrate (1) thereby to discharge signal charges accumulated in said signal charge accumulating region (3) to said substrate (1); wherein
said means (16 to 19) for applying said predetermined voltage is arranged to apply said predetermined voltage to said substrate (1) by selecting the time of supply of a discharging pulse (P₁),
characterized in that said means for applying said predetermined voltage are adapted such that
said discharging pulse (P₁) is applied to said substrate (1) just before the exposure time is started, and is not applied to said substrate (1) for some of the non-exposure time.

2. An electronic shutter as claimed in claim 1, wherein said discharging pulse (P₁) is applied to said substrate (1) a plurality of times in other than the exposure time.

3. An electronic shutter as claimed in any preceding claim, wherein the solid state imager device comprises a CCD image sensor.

4. A method of utilizing a solid state imager device as an electronic shutter for an electronic camera, comprising the step of applying a predetermined voltage to a semiconductor substrate (1) of a first conductivity type having a region (2) of a second conductivity type formed thereon, thereby to discharge signal charges accumulated in a signal charge accumulating region (3) formed on a surface side of said second conductivity type region (2) to said substrate (1); and
selecting the time of supply of a discharging pulse (P₁) to apply said predetermined voltage to said substrate (1),
the method being characterized in that said
discharging pulse (P₁) is applied to said substrate (1) just before the start of the exposure time, and is not applied to said substrate (1) for some of the non-exposure time.

5. A method as claimed in claim 4, including applying said discharging pulse (P₁) to said substrate (1) a plurality of times outside the exposure time.

6. A method as claimed in either of claims 4 or 5, wherein the solid state imager device comprises a CCD image sensor.

## Patentansprüche

1. Elektronischer Verschluß für eine elektronische Kamera, wobei der Verschluß aufweist:
eine Festkörper-Bildaufnehmervorrichtung mit einem Halbleitersubstrat (1) eines ersten Leitfähigkeitstyps,
eine auf dem Substrat (1) ausgebildete Region (2) eines zweiten Leitfähigkeitstyps,
eine Signalladungs-Akkumulierungsregion (3), die auf einer Oberflächenseite der Region des zweiten Leitfahigkeitstyps ausgebildet ist und
eine Einrichtung (16 bis 19) zum Anlegen einer vorbestimmten Spannung an das genannte Substrat (1), um dadurch die in der Signalladungs-Akkumulierungsregion (3) akkumulierten Signalladungen in das Substrat (1) zu entladen,
wobei die Einrichtung (16 bis 19) zum Anlegen der vorbestimmten Spannung so angeordnet ist, daß sie die vorbestimmte Spannung an das Substrat (1) anlegt, indem sie die Zeit wählt, in der ein Entladungsimpuls (P₁) zugeführt wird,
**dadurch gekennzeichnet,**
daß die Einrichtung zum Anlegen der vorbestimmten Spannung so ausgebildet ist, daß der Entladungsimpuls (P₁) unmittelbar vor dem Beginn der Belichtungszeit an das Substrat (1) angelegt wird und während eines Teils der Zeit, die nicht Belichtungszeit ist, nicht an das Substrat (1) angelegt wird

2. Elektronischer Verschluß nach Anspruch 1, bei dem der Entladungsimpuls (P₁) außerhalb der Belichtungszeit mehrere Male an das Substrat (1) angelegt wird.

3. Elektronischer Verschluß nach einem der vorhergehenden Ansprüche, bei dem die Festkörper-Bildaufnehmervorrichtung einen CCD-Bildsensor umfaßt.

4. Verfahren zur Verwendung einer Festkörper-Bildaufnehmervorrichtung als elektronischen Verschluß für eine elektronische Kamera mit dem Verfahrensschritt,
daß an ein Halbleitersubstrat (1) eines ersten Leitfähigkeitstyps, auf dem eine Region (2) eines zweiten Leitfahigkeitstyps ausgebildet ist, eine vorbestimmte Spannung angelegt wird und dadurch Signalladungen in das genannte Substrat (1) entladen werden, die in einer auf einer Oberflachenseite der Region (2) ausgebildeten Signalladungs-Akkumülierungsregion (3) akkumuliert sind, und
daß die Zeit für die Zuführung eines Entladungsimpulses (P₁) gewählt wird, um die vorbestimmte Spannung an das Substrat (1) anzzulegen,
**dadurch gekennzeichnet**,
daß der Entladungsimpuls (P₁) unmittelbar vor dem Beginn der Belichtungszeit an das Substrat (1) angelegt wird und wahrend eines Teils der Zeit, die nicht Belichtungszeit ist, nicht an das Substrat (1) angelegt wird.

5. Verfahren nach Anspruch 4, bei dem der Entladungsimpuls (P₁) außerhalb der Belichtungszeit mehrere Male an das Substrat (1) angelegt wird.

6. Verfahren nach Anspruch 4 oder 5, bei dem die Festkorper-Bildaufnehmervorrichtung einen CCD-Bildsensor umfaßt.

## Revendications

1. Obturateur électronique pour une caméra électronique, l'obturateur comprenant :
un dispositif imageur du type à état solide ayant un substrat de semi-conducteur (1) d'un premier type de conductivité ;
une région (2) d'un deuxième type de conductivité formée sur ledit substrat (1) ;
une région (3) d'accumulation de charges formant signal, qui est formée sur un côté de surface de ladite région du deuxième type de conductivité ; et
des moyens (16 à 19) servant à appliquer une tension prédéterminée audit substrat (1) de manière à décharger dans ledit substrat (1) des charges de signal qui se sont accumulées dans ladite région (3) d'accumulation de charges de signal ; où
lesdits moyens (16 à 19) servant à appliquer ladite tension prédéterminée sont conçus pour appliquer ladite tension prédéterminée audit substrat (1) par sélection du temps de délivrance d'une impulsion de décharge (P₁),
caractérisé en ce que lesdits moyens servant à appliquer ladite tension prédéterminée sont conçus de façon que ladite impulsion de décharge (P₁) soit appliquée audit substrat (1) juste avant que le temps d'exposition ne commence et ne soit pas appliqué audit substrat (1) pendant une certaine partie du temps de non-exposition.

2. Obturateur électronique selon la revendication 1, où ladite impulsion de décharge (P₁) est appliquée audit substrat (1) une pluralité de fois à des moments autres que le temps d'exposition pendant une période de trame.

3. Obturateur électronique selon l'une quelconque des revendications précédentes, où ledit dispositif imageur du type à état solide comprend un capteur d'images du type à dispositif de couplage de charges.

4. Procédé d'utilisation d'un dispositif imageur du type à état solide comme obturateur électronique pour une caméra électronique, comprenant l'opération qui consiste à appliquer une tension prédéterminée à un substrat de semi-conducteur (1) d'un premier type de conductivité sur lequel est formée une région (2) d'un deuxième type de conductivité, de manière à décharger dans ledit substrat (1) des charges de signal qui se sont accumulées dans une région (3) d'accumulation de charges de signal, laquelle est formée sur un côté de surface de ladite région du deuxième type de conductivité (2) ; et
sélectionner le temps de délivrance d'une impulsion de décharge (P₁) afin d'appliquer ladite tension prédéterminée audit substrat (1),
le procédé étant caractérisé en ce que ladite impulsion de décharge (P₁) est appliquée audit substrat (1) juste avant le début le temps d'exposition et n'est pas appliquée audit substrat (1) pendant une certaine partie du temps de non-exposition.

5. Procédé selon la revendication 4, comportant l'opération qui consiste à appliquer ladite impulsion de décharge (P₁) audit substrat (1) une pluralité de fois en dehors du temps d'exposition pendant une période de trame.

6. Procédé selon la revendication 4 ou 5, où le dispositif imageur du type à état solide comprend un capteur d'images du type à dispositif de couplage de charges.
